# EUROPEAN PATENT APPLICATION

(11) **EP 4 585 665 A1**
(43) Date of publication of application: **16.07.2025**
(21) Application number: 23862929.9
(22) Date of filing: 22.08.2023
(51) Int. Cl.: C09K 3/14, B24B 37/00, B24B 37/015, B24B 53/017, C09G 1/02, H01L 21/304

(54) **POLISHING AGENT, ADDITIVE SOLUTION FOR POLISHING AGENTS AND POLISHING METHOD**

(30) Priority: 07.09.2022 JP 2022142276; 01.03.2023 JP 2023030924
(71) Applicant: AGC INC., Chiyoda-ku, Tokyo 1008405 (JP)
(72) Inventor: NAKASHIMA Hideki, Tokyo 100-8405 (JP); KATO Tomoo, Tokyo 100-8405 (JP); AKAJI Masatoshi, Tokyo 100-8405 (JP); OKAMURA Yuzo, Tokyo 100-8405 (JP); IWAMOTO Hiroaki, Tokyo 100-8405 (JP)
(74) Representative: Müller-Boré & Partner Patentanwälte PartG mbB
(86) International application number: PCT/JP2023/030140
(87) International publication number: WO 2024/053390

(57) **Abstract**

A polishing agent, an additive solution for a polishing agent, and a polishing method by which it is possible to polish a surface to be polished containing a resin to a highly flattened state at a high speed are provided. A polishing agent for polishing a surface to be polished containing a resin contains abrasive grains, a water-soluble nitrogen-containing compound and water, in which the water-soluble nitrogen-containing compound contains a compound represented by below-shown Formulae (1) to (3) or a salt thereof. 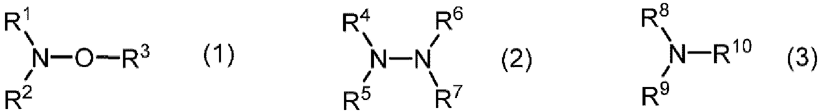 Note that reference numerals are as described in the specification.

## Description

### Technical Field

The present invention relates to a polishing agent, an additive solution for a polishing agent, and a polishing method.

### Background Art

As packing densities of semiconductor integrated circuits increase and their functions become more sophisticated, the development of microfabrication technology for making structures of semiconductor elements finer and more densified has been progressing. In the manufacturing of semiconductor integrated circuit devices (hereinafter also referred to as a semiconductor devices), conventionally, interlayer insulating films, buried wiring lines, and the like are flattened by using Chemical Mechanical Polishing (hereinafter referred to as CMP) in order to prevent a problem that irregularities (differences in level) on the surface of a layer exceed the focal depth of lithography and hence a sufficient resolution cannot be obtained.

Regarding the aforementioned CMP, in many cases, the surface to be polished is a silicon nitride film or a silicon oxide film of a semiconductor element. However, in recent years, studies in which the surface to be polished is a surface containing a resin have been conducted.

For example, Patent Literature 1 discloses a specific polishing composition containing alumina abrasive grains, glycine, a hydrogen peroxide solution, an anionic surfactant, and water as a polishing composition for polishing copper and a resin.

Further, Patent Literature 2 discloses a specific polishing agent obtained by combining silica particles (first abrasive grains) with particles to which an aluminum compound or the like is made to adhere (second abrasive grains).

### Citation List

### Patent Literature

Patent Literature 1: Japanese Unexamined Patent Application Publication No. 2019-116529
Patent Literature 2: Japanese Unexamined Patent Application Publication No. 2018-12752

### Summary of Invention

### Technical Problem

In recent years, 3D (three-dimensional) packaging in which two or more chips are stacked and packaged together has been commercially used in order to further increase the packing density of the semiconductor integrated circuit. In such 3D packaging, chips may be stacked with, for example, a redistribution layer (RDL) included therein. Therefore, a resin layer such as a redistribution layer is also required to be highly flattened. Further, since the number of steps in the manufacturing process increases in such 3D packaging, it is desired that polishing be performed at a higher speed in order to improve the efficiency of the manufacturing process.

In view of the above-described problems, an object of the present disclosure is to provide a polishing agent, an additive solution for a polishing agent, and a polishing method by which it is possible to polish a surface to be polished containing a resin to a highly flattened state at a high speed.

### Solution to Problem

The present disclosure provides a polishing agent, a polishing method, and an additive solution for a polishing agent having compositions specified in the below-shown Items [1] to [30].
[1] A polishing agent for polishing a surface to be polished containing a resin, containing abrasive grains, a water-soluble nitrogen-containing compound, and water, wherein
   the water-soluble nitrogen-containing compound contains a compound represented by below-shown Formulae (1) to (3) or a salt thereof: 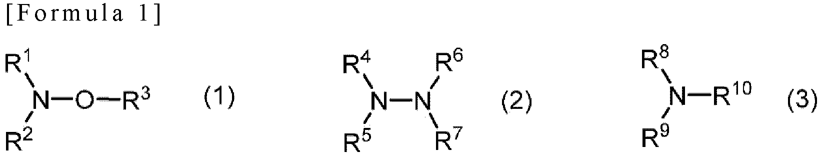
   where:
      (I) each of R¹ to R³ independently represents a hydrogen atom, an alkyl group which may contain a substituent and may contain an ether bond between carbon and carbon, an aryl group which may contain a substituent and may contain a hetero atom (an atom other than a hydrogen atom and a carbon atom), or a group represented by a below-shown Formula (1a), 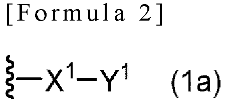
         X¹ represents -C(=O)-, -C(=O)-O-, -C(=O)-NH-, -C(=S)-O-, - C(=S)-S-, -S (=O)(=O)-, or -C(=NH)-NH-,
         Y¹ represents a hydrogen atom, an alkyl group which may contain a substituent and may contain an ether bond between carbon and carbon, an aryl group which may contain a substituent and may contain a hetero atom, a hydroxyl group, or an amino group, two groups selected from R¹ to R³ may be connected to each other and thereby form a ring structure, (II) each of R⁴ to R⁷ independently represents a hydrogen atom, an alkyl group which may contain a substituent and may contain an ether bond between carbon and carbon, an aryl group which may contain a substituent and may contain a hetero atom, a group represented by a below-shown Formula (2a), or a group represented by a below-shown Formula (2b), 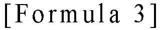 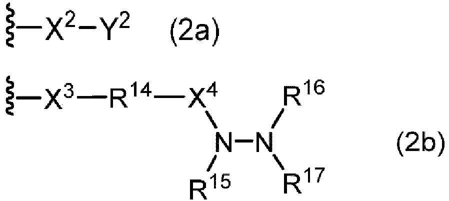
         X² represents a group selected from -C(=)-, -C(=O)-O-, -C(=O)-NH-, -C(=S)-O-, -C(=S)-S-, -S (=O)(=O)-, and -C(=NH)-NH-,
         Y² represents a hydrogen atom, an alkyl group which may contain a substituent and may contain an ether bond between carbon and carbon, an aryl group which may contain a substituent and may contain a hetero atom, a hydroxyl group, or an amino group;
         X³ represents -C(=O)-, -C(=O)-O-, -C(=O)-NH-, -C(=S)-O-, - C(=S)-S-, -S (=O)(=O)-, or -C(=NH)-NH-,
         R¹⁴ represents a single bond or an alkylene group which may contain a substituent and may contain an ether bond between carbon and carbon,
         X⁴ represents a single bond, -C(=O)-, -C(=O)-O-, -C(=O)-NH-, - C(=S)-O-, -C(=S)-S-, -S (=O)(=O)-, or -C(=NH)-NH-,
         each of R¹⁵ to R¹⁷ independently represents a hydrogen atom, an alkyl group which may contain a substituent and may contain an ether bond between carbon and carbon, an aryl group which may contain a substituent and may contain a hetero atom, or a group represented by the above-shown Formula (2a),
         two groups selected from R⁴ to R⁷ may be connected to each other and thereby form a ring structure,
         two groups selected from R¹⁵ to R¹⁷ may be connected to each other and thereby form a ring structure,
      (III) each of R⁸ to R¹⁰ independently represents a hydrogen atom, an alkyl group which may contain an aryl group, an amino group, or a halogen atom as a substituent and may contain an ether bond between carbon and carbon, or a group represented by a below-shown Formula (3a), where at least one of R⁸ to R¹⁰ is a group other than a hydrogen atom, 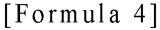 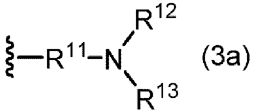
         R¹¹ represents an alkylene group which may contain a substituent and may contain an ether bond between carbon and carbon,
         each of R¹² and R¹³ independently represents a hydrogen atom, or an alkyl group which may contain a substituent and may contain an ether bond between carbon and carbon, and
         two or three atoms or groups selected from R⁸ to R¹⁰ may be connected to each other and thereby form a ring structure.
[2] The polishing agent according to Item [1], wherein the water-soluble nitrogen-containing compound contains a compound represented by the above-shown Formula (1) or a salt thereof.
[3] The polishing agent according to Item [1] or [2], wherein the compound represented by the above-shown Formula (1) contains at least one compound selected from hydroxylamine, N-methylhydroxylamine, N-hydroxyacetamide, N-hydroxycarbamate-tert-butyl, hydroxyurea, O-methylhydroxylamine, O-(tetrahydropyran-2-yl)hydroxylamine, carboxymethoxylamine, N,O-dimethylhydroxylamine, and N,N-dimethylhydroxylamine.
[4] The polishing agent according to any one of Items [1] to [3], wherein the compound represented by the above-shown Formula (1) contains at least one compound selected from hydroxylamine, O-methylhydroxylamine, and N,O-dimethylhydroxylamine.
[5] The polishing agent according to any one of Items [1] to [4], wherein the water-soluble nitrogen-containing compound contains a compound represented by the above-shown Formula (2) or a salt thereof.
[6] The polishing agent according to any one of Items [1] to [5], wherein the compound represented by the above-shown Formula (2) contains at least one compound selected from hydrazine, formohydrazide, acetohydrazide, tert-butoxycarbonylhydrazine, isonicotinic acid hydrazide, adipic acid dihydrazide, carbohydrazide, 1,1-dimethylhydrazine, 1-pyrrolidineamine, 4-aminomorpholine, 1-aminopiperidine, 1-amino-4-methylpiperazine, thiosemicarbazide, thiocarbohydrazide, oxamic acid hydrazide, 4-methylthiosemicarbazide, aminoguanidine, 1,3-diaminoguanidine, semicarbazide, N-aminophthalimide, 2-hydrazinoethanol, isopropylhydrazine, methylhydrazine, cyclohexylhydrazine, phenylhydrazine, and 2-hydrazinopyridine.
[7] The polishing agent according to any one of Items [1] to [6], wherein the compound represented by the above-shown Formula (2) contains at least one compound selected from aminoguanidine, 2-hydrazinoethanol, isopropylhydrazine, and adipic acid dihydrazide.
[8] The polishing agent according to any one of Items [1] to [7], wherein
   the water-soluble nitrogen-containing compound contains a compound represented by the above-shown Formula (3) or a salt thereof,
   at least two groups among R⁸ to R¹⁰ are groups other than a hydrogen atom,
   two groups selected from R⁸ to R¹⁰ are connected to each other through a divalent connecting group and thereby form a ring structure, or
   three atoms or groups of R⁸ to R¹⁰ are connected to each other through a trivalent connecting group and thereby form a ring structure.
[9] The polishing agent according to any one of Items [1] to [8], wherein the compound represented by the above-shown Formula (3) contains at least one compound selected from triethylenediamine, hexamethylenetetramine, quinuclidine, 3-quinuclidinol, 3-quinuclidinone, quinidine, quinine, cinchonidine, cinchonine, piperazine, and 4-dimethylaminopyridine.
[10] The polishing agent according to any one of Items [1] to [9], wherein the compound represented by the above-shown Formula (3) contains at least one compound selected from triethylenediamine and hexamethylenetetramine.
[11] The polishing agent according to any one of Items [1] to [10], wherein
   the water-soluble nitrogen-containing compound contains a compound represented by the above-shown Formula (3) or a salt thereof, and
   each of R⁸ to R¹⁰ independently represents an alkyl group which may contain a substituent and may contain an ether bond between carbon and carbon, and a molecular weight (in a case of a salt, a molecular weight of only a part represented by Formula (3)) is 500 or smaller.
[12] The polishing agent according to any one of Items [1] to [11], wherein the compound represented by the above-shown Formula (3) contains at least one compound selected from trimethylamine and triethylamine.
[13] The polishing agent according to any one of Items [1] to [12], wherein the compound represented by the above-shown Formula (3) contains triethylamine.
[14] The polishing agent according to any one of Items [1] to [13], wherein
   the water-soluble nitrogen-containing compound contains a compound represented by the above-shown Formula (3) or a salt thereof, and
   each of R⁸ to R¹⁰ independently represents a hydrogen atom or a group represented by the above-shown Formula (3a), where: at least one of R⁸ to R¹⁰ represents a group other than a hydrogen atom; R¹² and R¹³ are hydrogen atoms; and a molecular weight (in a case of a salt, a molecular weight of only a part represented by Formula (3)) is 500 or smaller.
[15] The polishing agent according to any one of Items [1] to [14], wherein the compound represented by the above-shown Formula (3) contains at least one compound selected from ethylenediamine, propylenediamine, butylenediamine, and polyetheramine.
[16] The polishing agent according to any one of Items [1] to [15], wherein the compound represented by the above-shown Formula (3) contains at least one compound selected from ethylenediamine and polyetheramine.
[17] The polishing agent according to any one of Items [1] to [16], wherein a content of the water-soluble nitrogen-containing compound is 0.001 wt.% to 1.5 wt.% based on a total mass of the polishing agent.
[18] The polishing agent according to any one of Items [1] to [17], wherein the abrasive grains contain at least one compound selected from the group consisting of silica particles, alumina particles, zirconia particles, ceria particles, titania particles, germania particles, cerium hydroxide particles, and composite particles thereof.
[19] The polishing agent according to any one of Items [1] to [18], wherein the abrasive grains contain ceria particles.
[20] The polishing agent according to any one of Items [1] to [19], wherein a content of the abrasive grains is 0.01 wt.% to 10.0 wt.% based on a total weight of the polishing agent.
[21] The polishing agent according to any one of Items [1] to [20], further comprising a pH adjusting agent.
[22] The polishing agent according to Item [21], wherein the pH adjusting agent contains at least one compound selected from nitric acid, sulfuric acid, hydrochloric acid, phosphoric acid, sodium hydroxide, potassium hydroxide, ammonium hydroxide, potassium carbonate, sodium carbonate, ammonium carbonate, monoethanolamine, diethanolamine, and triethanolamine.
[23] The polishing agent according to any one of Items [1] to [22], further comprising an organic acid.
[24] The polishing agent according to Item [23], wherein the organic acid is a monovalent monocarboxylic acid.
[25] The polishing agent according to Item [23], wherein the organic acid contains at least one compound selected from acetic acid, picolinic acid, cyclopentanecarboxylic acid, glycine, 2-hydroxyisobutyric acid, and pyruvic acid.
[26] The polishing agent according to Item [1] to [25], wherein pH is 3.6 to 12.0.
[27] A polishing method for polishing a surface to be polished containing a resin by bringing the surface to be polished into contact with a polishing pad while supplying a polishing agent, and polishing the surface to be polished by relative motion of the surface to be polished and the polishing pad, wherein a polishing agent according to any one of Items [1] to [26] is used as the polishing agent.
[28] The polishing method according to Item [27], wherein a temperature of the surface to be polished during the polishing is 30°C to 80°C.
[29] The polishing method according to Item [27] or [28], wherein a pad conditioning pressure during the polishing is 13 N to 45 N.
[30] An additive solution for a polishing agent used to polish a surface to be polished containing a resin, containing a water-soluble nitrogen-containing compound and water, wherein
   the water-soluble nitrogen-containing compound contains a compound represented by the above-shown Formulae (1) to (3) or a salt thereof.

### Advantageous Effects of Invention

According to the present disclosure, it is possible to provide a polishing agent, an additive solution for a polishing agent, and a polishing method by which it is possible to polish a surface to be polished containing a resin to a highly flattened state at a high speed.

### Brief Description of Drawings

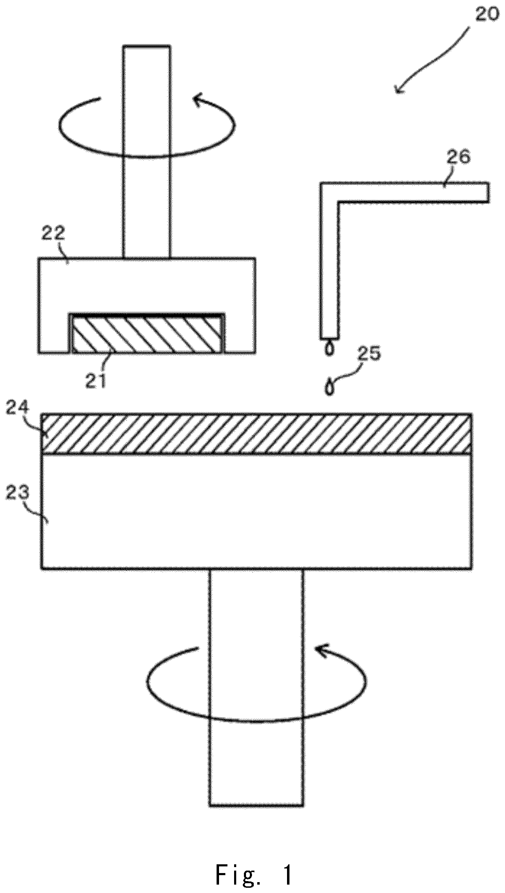

Fig. 1 is a schematic diagram showing an example of a polishing apparatus.

### Description of Embodiments

Embodiments according to the present disclosure will be described hereinafter. For clarifying the explanation, the following description and drawings are simplified as appropriate. Further, for the sake of explanation, the scales of members in the drawings may widely differ from one another.

Note that in the present disclosure, the term "surface to be polished" means a surface to be polished of an object to be polished, for example, a front surface thereof. In the specification of the present application, surfaces at intermediate stages, i.e., surfaces that appear during a polishing process, are also included in the "surface to be polished".

In the present disclosure, the term "water-soluble" means that "a substance having an amount of 10 mg or more is dissolved in 100g of water at 25°C".

When a symbol "-" (or "to"), which indicates a numerical range, is used, it means that a numerical value in front of the symbol and that behind the symbol are included as a lower limit value and an upper limit value, respectively, in the range.

Further, for example, "R¹ - R³" (or "R¹ to R³") represents "R¹, R² and R³", and this also applies to other symbols connected by "-" (or "to").

In the specification of the present application, "compound represented by Formula (1)" may also be referred to as "Compound (1)", and this also applies to other compounds.

Further, when there are a plurality of same symbols in one chemical formula, these same symbols are not limited to those representing the same substituents, but may also represent substituents different from each other within the range specified for these symbols.

### [Polishing Agent]

A polishing agent according to the present disclosure is a polishing agent for polishing a surface to be polished containing a resin, containing:
abrasive grains, a water-soluble nitrogen-containing compound, and water, in which
the water-soluble nitrogen-containing compound contains a compound represented by below-shown Formulae (1) to (3) or a salt thereof (hereinafter also referred to simply as a nitrogen-containing compound). 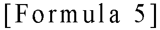 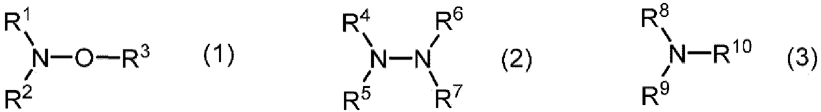
where:
   (I) each of R¹ to R³ independently represents a hydrogen atom, an alkyl group which may contain a substituent and may contain an ether bond between carbon and carbon, an aryl group which may contain a substituent and may contain a hetero atom, or a group represented by a below-shown Formula (1a), 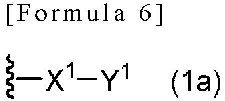
      X¹ represents -C(=O)-, -C(=O)-O-, -C(=O)-NH-, -C(=S)-O-, - C(=S)-S-, -S (=O)(=O)-, or -C(=NH)-NH-,
      Y¹ represents a hydrogen atom, an alkyl group which may contain a substituent and may contain an ether bond between carbon and carbon, an aryl group which may contain a substituent and may contain a hetero atom, a hydroxyl group, or an amino group,
      two groups selected from R¹ to R³ may be connected to each other and thereby form a ring structure,
   II) each of R⁴ to R⁷ independently represents a hydrogen atom, an alkyl group which may contain a substituent and may contain an ether bond between carbon and carbon, an aryl group which may contain a substituent and may contain a hetero atom, a group represented by a below-shown Formula (2a), or a group represented by a below-shown Formula (2b), 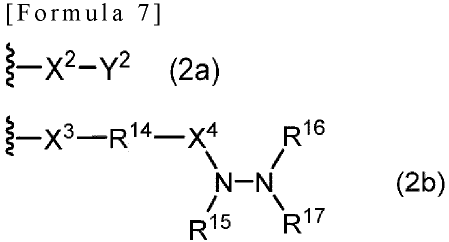
      X² represents a group selected from -C(=)-, -C(=O)-O-, -C(=O)-NH-, -C(=S)-O-, -C(=S)-S-, -S (=O)(=O)-, and -C(=NH)-NH-,
      Y² represents a hydrogen atom, an alkyl group which may contain a substituent and may contain an ether bond between carbon and carbon, an aryl group which may contain a substituent and may contain a hetero atom, a hydroxyl group, or an amino group;
      X³ represents -C(=O)-, -C(=O)-O-, -C(=O)-NH-, -C(=S)-O-, - C(=S)-S-, -S (=O)(=O)-, or -C(=NH)-NH-,
      R¹⁴ represents a single bond or an alkylene group which may contain a substituent and may contain an ether bond between carbon and carbon,
      X⁴ represents a single bond, -C(=O)-, -C(=O)-O-, -C(=O)-NH-, - C(=S)-O-, -C(=S)-S-, -S (=O)(=O)-, or -C(=NH)-NH-,
      each of R¹⁵ to R¹⁷ independently represents a hydrogen atom, an alkyl group which may contain a substituent and may contain an ether bond between carbon and carbon, an aryl group which may contain a substituent and may contain a hetero atom, or a group represented by the above-shown Formula (2a),
      two groups selected from R⁴ to R⁷ may be connected to each other and thereby form a ring structure,
      two groups selected from R¹⁵ to R¹⁷ may be connected to each other and thereby form a ring structure,
   (III) each of R⁸ to R¹⁰ independently represents a hydrogen atom, an alkyl group which may contain an aryl group, an amino group, or a halogen atom as a substituent and may contain an ether bond between carbon and carbon, or a group represented by a below-shown Formula (3a), where at least one of R⁸ to R¹⁰ is a group other than a hydrogen atom, 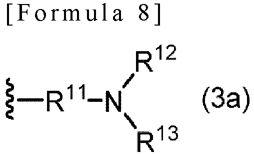
      R¹¹ represents an alkylene group which may contain a substituent and may contain an ether bond between carbon and carbon,
      each of R¹² to R¹³ independently represents a hydrogen atom, or an alkyl group which may contain a substituent and may contain an ether bond between carbon and carbon, and
      two or three atoms or groups selected from R⁸ to R¹⁰ may be connected to each other and thereby form a ring structure.

In the polishing agent according to the present disclosure, the lone electron pair of a nitrogen atom contained in the aforementioned nitrogen-containing compound is nucleophilic. Therefore, it is presumed that this nitrogen-containing compound acts on the electrophilic part in the resin in the surface layer of the surface to be polished which is in contact with the nitrogen-containing compound, and hence the material strength of the resin decreases. As a result, it is possible to perform high-speed polishing while reducing the force applied to the surface to be polished and thereby suppressing the polishing damage, and therefore to achieve highly-flat polishing.

The polishing agent according to the present disclosure contains at least abrasive grains, a water-soluble nitrogen-containing compound, and water, and may further contain other components as long as the effects of the present invention are achieved. Each of the components contained in the polishing agent according to the present disclosure will be described hereinafter.

### <Abrasive Grains>

The abrasive grains may be selected as appropriate from those used as abrasive grains for CMP. Examples of abrasive grains include at least one type selected from the group consisting of silica particles, alumina particles, zirconia particles, cerium compound particles (e.g., ceria particles, cerium hydroxide particles), titania particles, germania particles, and core-shell type particles using these particles as core particles. Examples of the silica particles include colloidal silica and fumed silica. Colloidal alumina may also be used as the alumina particles.

The core-shell type particles consist of core particles (e.g., silica particles, alumina particles, zirconia particles, cerium compound particles, titania particles, or germania particles) and thin films covering the surfaces of the core particles.

Examples of the material of the thin film include at least one type selected from oxides such as silica, alumina, zirconia, ceria, titania, germania, iron oxide, manganese oxide, zinc oxide, yttrium oxide, calcium oxide, magnesium oxide, lanthanum oxide, and strontium oxide. Further, the thin film may be formed from a plurality of nanoparticles consisting of these oxides.

The particle size of the aforementioned core particles is preferably 0.01 µm to 0.5 µm and more preferably 0.03 µm to 0.3 µm.

It is sufficient if the particle size of the aforementioned nanoparticles is smaller than the particle size of the aforementioned core particles, and the particle size of the nanoparticles preferably 1 nm to 100 nm and more preferably 5 nm to 80 nm.

Among the above-mentioned abrasive grains, silica particles, alumina particles, or cerium compound particles are preferred in view of the excellent removal rate of the insulating film. Further, cerium compound particles are more preferred, and ceria particles are further preferred because a high removal rate can be achieved when the surface to be polished includes an insulating film (in particular, a silicon oxide film). In the case of core-shell type particles, the thin film preferably contains silica, alumina, or a cerium compound. More preferably, the thin film contains ceria. Only one type of abrasive grains may be used, or two or more types of abrasive grains may be used in combination.

When the abrasive grains include composite particles, or when the abrasive grains include two or more types of particles, the content of the aforementioned metal oxide (e.g., silica, alumina, or ceria) based on the total mass of the abrasive grains is preferably 70 wt.% or more, more preferably 80 wt.% or more, further preferably 90 wt.% or more, particularly preferably 95 wt.% or more, and most preferably 100 wt.%. When the content of the metal oxide based on the total mass of the abrasive grains is 70 wt.% or more, a high removal rate of the resin is easily achieved.

Ceria particles may be selected as appropriate from known ones and used. Examples of know ceria particles include ceria particles manufactured by methods disclosed in Japanese Unexamined Patent Application Publication No. H11-12561, Japanese Unexamined Patent Application Publication No. 2001-35818, and Published Japanese Translation of PCT International Publication for Patent Application, No. 2010-505735. Specifically, examples of them include ceria particles obtained by manufacturing cerium hydroxide gel by adding an alkali to an aqueous solution of cerium(IV) ammonium nitrate, and then filtering, washing, and firing the manufactured gel; the ceria particles obtained by pulverizing and then firing highly-pure ceria carbonate, and further pulverizing and classifying the pulverized and fired ceria carbonate; and ceria particles obtained by chemically oxidizing a cerium(III) salt in a liquid.

The ceria particles may contain impurities other than ceria. However, the content of ceria in one ceria particle is preferably 80 wt.% or more, more preferably 90 wt.% or more, further preferably 95% or more, and most preferably 100 wt.% (containing no impurities). When the content of ceria in a ceria particle is 80 wt.% or more, a high removal rate of the resin is easily achieved.

The average particle size of the abrasive grains is preferably 0.01 µm to 0.5 µm and more preferably 0.03 µm to 0.3 µm. When the average particle size is 0.5 µm or shorter, the occurrence of polishing damage such as scratches on the surface to be polished is suppressed. Further, when the average particle size is 0.01 µm or longer, the aggregation of abrasive grains is suppressed, so that the storage stability of the polishing agent is excellent and the removal rate is also excellent.

Note that since the abrasive grains exist as aggregated particles (secondary particles) in which primary particles are aggregated in the liquid, the above-described average particle size is the average secondary particle size. The average secondary particle size is measured by using a dispersion liquid in which secondary particles are dispersed in a dispersion medium such as pure water and using a particle-size distribution meter such as a laser diffraction/scattering type meter.

The content of the abrasive grains is preferably 0.01 wt.% to 10.0 wt.%, more preferably 0.05 wt.% to 2.0 wt.%, further preferably 0.1 wt.% to 1.5 wt.%, and particularly preferably 0.15 wt.% to 1.0 wt.% based on the total mass of the polishing agent. When the content ratio of the abrasive grains is equal to or higher than the above-mentioned lower limit value, an excellent removal rate for the surface to be polished is achieved. On the other hand, when the content ratio of the abrasive grains is equal to or lower than the above-mentioned upper limit value, an increase in the viscosity of the polishing agent is suppressed and the handleability is excellent.

### <Water-Soluble Nitrogen-Containing Compound>

A polishing agent according to the present disclosure contains a compound represented by the below-shown Formulae (1) to (3) or a salt thereof. Note that only one type of water-soluble nitrogen-containing compound may be used, or two or more types of water-soluble nitrogen-containing compounds may be used in combination.

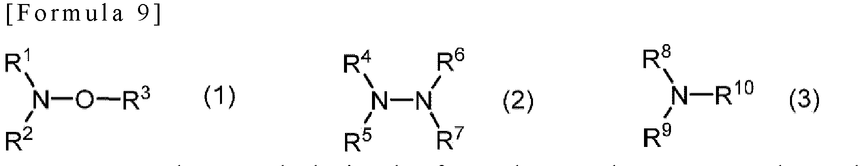

Note that symbols in the formula are the same as those described above.

### (I) Compound (1)

The alkyl group in R¹ to R³ preferably has a carbon number of 1 to 12 and more preferably 1 to 6. This alkyl group may be a straight chain and/or may have a branch and/or a ring structure. Specific examples of the alkyl group include a methyl group, an ethyl group, an n-butyl group, a tert-butyl group, and a cyclohexyl group. Further, the alkyl group may contain an ether bond between carbon and carbon. Specific examples of such alkyl groups include a methoxymethyl group, an ethoxymethyl group, a tetrahydropyryl group, and a polyether (-[(CH₂)ₙO]ₘ-R (where: n is an integer of 1 to 6; m is an integer of 2 or larger; and R is a hydrogen atom or an alkyl group having a carbon number of 1 to 6). Further, examples of the substituent which the alkyl group may contain include an aryl group which may contain a hetero atom, an amino group, and a halogen atom. Examples of the aryl group which may contain a hetero atom include a phenyl group, a naphthyl group, furan, thiophene, pyrrole, oxazole, imidazole, pyran, pyridine, and quinoline. Further, examples of the halogen atom include F, Cl, Br and I. Note that examples of the hetero atom include N, O, S and Si.

Examples of the aryl group in R¹ to R³ include a phenyl group and a naphthyl group. Examples of the aryl group containing a hetero atom (i.e., the heteroaryl group) include a residue such as furan, thiophene, pyrrole, oxazole, imidazole, pyran, pyridine, and quinoline. Further, examples of the substituent which the aryl group may contain include an alkyl group, an amino group, and a halogen atom. Examples of the alkyl group as the substituent include an alkyl group having a straight chain or a branch and having a carbon number of 1 to 6. Examples of the aryl group include a phenyl group and a naphthyl group. Further, examples of the halogen atom include F, Cl, Br and I. 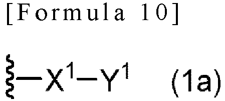 In the group represented by Formula (1a), X¹ is as described above. In Y¹, the alkyl group which may contain a substituent and may contain an ether bond between carbon and carbon, and the aryl group which may contain a substituent and may contain a hetero atom are similar to those in R¹ to R³.

In the ring structure that is formed as two groups selected from R¹ to R³ are connected to each other, for example, R¹ and R² may be directly connected to each other and thereby form one alkylene group or the like, or a connecting group such as an arylene group may be interposed between R¹ and R². The arylene group may contain a hetero atom or a substituent. Specific examples of the arylene group include a divalent residue such as benzene, naphthalene, furan, thiophene, pyrrole, oxazole, imidazole, pyran, pyridine, and quinoline.

Examples of the salt of the compound represented by the above-shown Formula (1) include sulfate, hydrochloride, and nitrate.

The molecular weight of the above-described Compound (1) (in the case of a salt, the molecular weight of only the part represented by Formula (1) excluding the anion part) is not limited to any particular values, but is preferably 1,000 or smaller and more preferably 500 or smaller in order to improve the resin removal rate.

Specific examples of Compound (1) include hydroxylamine-based compounds such as hydroxylamine, N-methylhydroxylamine, N-hydroxyacetamide, N-hydroxycarbamate-tert-butyl, hydroxyurea, O-methylhydroxylamine, O-(tetrahydropyran-2-yl)hydroxylamine, carboxymethoxylamine, N,O-dimethylhydroxylamine, and N,N-dimethylhydroxylamine.

Among them, hydroxylamine, O-methylhydroxylamine, and N,O-dimethylhydroxylamine are preferred in order to improve the resin removal rate.

### (II) Compound (2)

The alkyl group and aryl group in R⁴ to R⁷ are similar to those in R¹ to R³, and their preferred embodiments are also similar to those in R¹ to R³.

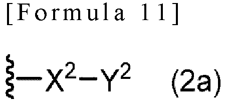

X² and Y² in Formula (2a) are similar to X¹ and Y¹, respectively, in Formula (1a), and their preferred embodiments are also similar to those of X¹ and Y¹.

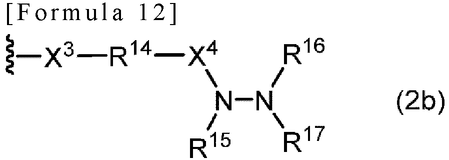

X³ in Formula (2b) is similar to X¹ in Formula (1a).

The alkylene group in R¹⁴ preferably has a carbon number of 1 to 12 and more preferably 1 to 6.

This alkylene group may be a straight chain and/or may have a branch and/or a ring structure. Specific examples of the alkylene group include a methylene group, an ethylene group, and a butylene group. Further, the alkylene group may contain an ether bond between carbon and carbon. Specific examples of such an alkylene group include -CH₂OCH₂₋, -C₂H₅OCH₂₋, -C₂H₅OC₂H₅₋, polyether(-[(CH₂)ₙ₁O]ₘ-(CH₂)ₙ₂₋ (where each of n1 and n2 independently represents an integer of 1 to 6, and m is an integer of 2 or larger). Further, the substituent which the alkylene group may contain is similar to those which the alkyl group in R¹ to R³ may contain.

Further, R¹⁴ may be a single bond. When R¹⁴ is a single bond, X³ and X⁴, or X³ and N are directly bonded to each other.

X⁴ is similar to X¹ in the above-shown Formula (1a), or is a single bond.

The alkyl group, the aryl group, and the group represented by Formula (2a) in R¹⁵ to R¹⁷ are similar to those in R⁴ to R⁷.

The ring structure that is formed as two groups selected from R⁴ to R⁷ are connected to each other, and the ring structure that is formed as two groups selected from R¹⁵ to R¹⁷ are connected to each other are both similar to the ring structure that is formed as two groups selected from R¹ to R³ are connected to each other. That is, the above-described features are applied by replacing R¹ to R³ by R⁴ to R⁷ or by R¹⁵ to R¹⁷.

Examples of the salt of the compound represented by the above-shown Formula (2) include sulfate, hydrochloride, and nitrate.

The molecular weight of the above-described Compound (2) (in the case of a salt, the molecular weight of only the part represented by Formula (2) excluding the anion part) is not limited to any particular values, but is preferably 1,000 or smaller and more preferably 500 or smaller in order to improve the resin removal rate.

Specific examples of Compound (2) include hydrazine-based compounds such as hydrazine, formohydrazide, acetohydrazide, tert-butoxycarbonylhydrazine, isonicotinic acid hydrazide, adipic acid dihydrazide, carbohydrazide, 1,1-dimethylhydrazine, 1-pyrrolidineamine, 4-aminomorpholine, 1-aminopiperidine, 1-amino-4 methylpiperazine, thiosemicarbazide, thiocarbohydrazide, oxamic acid hydrazide, 4-methylthiosemicarbazide, aminoguanidine, 1,3-diaminoguanidine, semicarbazide, N-aminophthalimide, 2-hydrazinoethanol, isopropylhydrazine, methylhydrazine, cyclohexylhydrazine, phenylhydrazine, and 2-hydrazinopyridine.

Among them, aminoguanidine, 2-hydrazinoethanol, isopropylhydrazine, and adipic acid dihydrazide are preferred in order to improve the resin removal rate.

### (III) Compound (3)

The alkyl group in R⁸ to R¹⁰ is similar to that in R¹ to R³, and examples of the substituent of the alkyl group in R⁸ to R¹⁰ include an aryl group, an amino group, and a halogen atom. Preferred embodiments in R⁸ to R¹⁰ are similar to those in R¹ to R³.

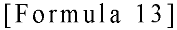

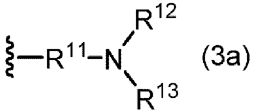

R¹¹ in Formula (3a) is similar to that in R¹⁴, and its preferred embodiments are also similar to those in R¹⁴.

The alkyl group in R¹² to R¹³ is similar to that in R¹ to R³, and its preferred embodiments are also similar to those in R¹ to R³.

In the ring structure that is formed as two groups selected from R⁸ to R¹⁰ are connected to each other, for example, R⁸ and R⁹ may be directly connected to each other and thereby form one alkylene group or the like, or a divalent hydrocarbon group such as an arylene group may be interposed between R⁸ and R⁹ as a connecting group. Further, when R⁸ is a group represented by Formula (3a), R¹² and R⁹ may be connected to each other, or R¹², R¹³ and R⁹ may be connected to each other. In this case, the ring structure may contain a trivalent hydrocarbon group as a connecting group.

Further, in the ring structure that is formed as three atoms or groups selected from R⁸ to R¹⁰ are connected to each other, for example, R⁸ to R¹⁰ may be directly connected to each other and thereby form a bridged alicyclic structure, or the ring structure may contain a trivalent hydrocarbon group which connects R⁸ to R¹⁰ to each other as a connecting group. Further, when R⁸ is a group represented by Formula (3a), R¹², R⁹ and R¹⁰ may be connected to each other, or R¹², R¹³, R⁹ and R¹⁰ may be connected to each other. In this case, the ring structure may contain a tetravalent hydrocarbon group as a connecting group.

Examples of the salt of the compound represented by the above-shown Formula (3) include sulfate, hydrochloride, and nitrate.

The molecular weight of the above-described Compound (3) (in the case of a salt, the molecular weight of only the part represented by Formula (3) excluding the anion part) is not limited to any particular values, but is preferably 1,000 or smaller and more preferably 500 or smaller in order to improve the resin removal rate.

Compound (3) preferably satisfies one of the below-shown conditions (III-1) to (III-3) in order to improve the resin removal rate. (III-1) At least two of the above-shown R⁸ to R¹⁰ are groups other than a hydrogen atom,
two groups selected from R⁸ to R¹⁰ are connected to each other through a divalent connecting group and thereby form a ring structure, or
three of the above-shown R⁸ to R¹⁰ are connected to each other through a trivalent connecting group and thereby form a ring structure; (III-2) Each of the above-shown R⁸ to R¹⁰ independently represents an alkyl group which may contain a substituent and may contain an ether bond between carbon and carbon, and the molecular weight (in the case of a salt, the molecular weight of only a part represented by Formula (3)) is 500 or smaller; and
(III-3) The above-described water-soluble nitrogen-containing compound contains a compound represented by the above-shown Formula (3) or a salt thereof, and each of the above-shown R⁸ to R¹⁰ independently represents a hydrogen atom or a group represented by the above-shown Formula (3a), where: at least one of R⁸ to R¹⁰ represents a group other than a hydrogen atom; R¹² and R¹³ are hydrogen atoms; and the molecular weight (in the case of a salt, the molecular weight of only a part represented by Formula (3)) is 500 or smaller.

Specific examples of the compound included in the above-shown Item (III-1) include triethylenediamine, hexamethylenetetramine, quinuclidine, 3-quinuclidinol, 3-quinuclidinone, quinidine, quinine, cinchonidine, cinchonine, piperazine, and 4-dimethylaminopyridine.

Among them, triethylenediamine and hexamethylenetetramine are preferred in order to improve the resin removal rate.

Specific examples of the compound included in the above-shown Item (III-2) include trimethylamine and triethylamine. Further, triethylamine is preferred in order to improve the resin removal rate.

Specific examples of the compound included in the above-shown Item (III-3) include ethylenediamine, propylenediamine, butylenediamine, and polyetheramine.

Among them, ethylenediamine and polyetheramine are preferred in order to improve the resin removal rate.

In order to improve the resin removal rate, the nitrogen-containing compound preferably contains, among others, at least one type selected from hydroxylamine, N-methylhydroxylamine, O-methylhydroxylamine, N,O-dimethylhydroxylamine, N,N-dimethylhydroxylamine, triethylenediamine, ethylenediamine, hexamethylenetetramine, triethylamine, 2-hydrazinoethanol, adipic acid dihydrazide, isopropylhydrazine, aminoguanidine, and salts thereof.

In the polishing agent according to the present disclosure, the molecular weight of the nitrogen-containing compound (in the case of a salt, the anion part is excluded) is preferably 500 or smaller, more preferably 400 or smaller, further preferably 300 or smaller, particularly preferably 200 or smaller, and extremely preferably 150 or smaller in view of the ease of the interaction with the resin of the surface to be polished.

The content of the nitrogen-containing compound is preferably 0.001 wt.% to 10.0 wt.%, more preferably 0.01 wt.% to 2.0 wt.%, and further preferably 0.05 wt.% to 1.5 wt.% based on the total mass of the polishing agent. By adjusting the content ratio of the nitrogen-containing compound within the above-described range, it is possible to polish the surface to be polished containing a resin to a highly flattened state at a higher speed.

### <Water>

A polishing agent according to the present disclosure contains water as a medium in which abrasive grains (A) and a metal salt (B) are dispersed. Although the type of water is not limited to any particular types, it is preferred to use pure water, ultrapure water, ion-exchanged water, or the like in consideration of the effect on the water-soluble polymer or the like, the prevention of contamination with impurities, and the effect on the pH or the like.

### <Other Components>

A polishing agent according to the present disclosure may further contain other components as long as the effects of the present invention are achieved. Examples of other components include an organic acid, a pH adjusting agent, a water-soluble polymer, an aggregation inhibitor, a dispersant, a lubricant, a viscosity imparting agent, a viscosity adjusting agent, and a preservative.

### (Organic Acid)

A polishing agent according to the present disclosure may contain an organic acid. By containing the organic acid, the dispersion of the abrasive grains is improved, so that it is possible to polish the surface to be polished containing a resin to a highly flattened state at a higher speed. Further, since the organic acid is an acidic compound, it can also function as a pH adjusting agent (which will be described later). Note that the organic acid may be in the form of an organic acid salt.

Examples of the organic acid include compounds containing a carboxy group, a sulfo group or a phospho group as an acidic group, and also include an ammonium salt, a sodium salt, a potassium salt or the like of such compounds.

Examples of the organic acid containing a carboxy group include alkyl monocarboxylic acids such as formic acid, acetic acid, and propionic acid;
carboxylic acids having a heterocycle such as 2-pyridinecarboxylic acid, 3-pyridinecarboxylic acid, 4-pyridinecarboxylic acid, 2,3-pyridinedicarboxylic acid, 2,4-pyridinedicarboxylic acid, 2,5-pyridinedicarboxylic acid, 2,6-pyridinedicarboxylic acid, 3,4-pyridinedicarboxylic acid, 3,5-pyridinedicarboxylic acid, pyrazinecarboxylic acid, 2,3-pyrazinedicarboxylic acid, 2-quinolinecarboxylic acid, pyroglutamic acid, picolinic acid, DL-pipecolic acid, 2-furancarboxylic acid, 3-furancarboxylic acid, tetrahydrofuran-2-carboxylic acid, tetrahydrofuran-2,3,4,5-tetracarboxylic acid;
alicyclic carboxylic acids such as cyclopentanecarboxylic acid, cyclohexanecarboxylic acid, cycloheptanecarboxylic acid, and cyclohexylcarboxylic acid;
carboxylic acids containing an amino group such as alanine, glycine, glycylglycine, aminobutyric acid, N-acetylglycine, N,N-di(2-hydroxyethyl)glycine, N-(tert-butoxycarbonyl)glycine, proline, trans-4-hydroxy-L-proline, phenylalanine, sarcosine, hydantoic acid, creatine, N-[tris(hydroxymethyl)methyl]glycine, glutamic acid, and aspartic acid;
carboxylic acids containing a hydroxyl group such as lactic acid, malic acid, citric acid, tartaric acid, glycolic acid, gluconic acid, salicylic acid, 2-hydroxyisobutyric acid, glyceric acid, 2,2-bis(hydroxymethyl)propionic acid, and 2,2-bis(hydroxymethyl)butyric acid;
carboxylic acids (keto acids) such as pyruvic acid, acetoacetic acid, and levulinic acid; and
dicarboxylic acids such as oxalic acid, malonic acid, succinic acid, fumaric acid, maleic acid, glutaric acid, adipic acid, and phthalic acid.

As the organic acid having a carboxy group, monovalent monocarboxylic acids are preferred. Among them, the above-mentioned acetic acid, picolinic acid, cyclopentanecarboxylic acid, glycine, 2-hydroxyisobutyric acid, and pyruvic acid are more preferred.

The lower limit value of the content ratio of the organic acid is 0.0001 wt.%, preferably 0.001 wt.%, and more preferably 0.01 wt.% based on the total mass of the polishing agent. On the other hand, when the organic acid is 0.0001 wt.% or more, the upper limit value of its content ratio is 1 wt.%, preferably 0.5 wt.%, more preferably 0.3 wt.%, further preferably 0.1 wt.%, and particularly preferably 0.05 wt.% based on the total mass of the polishing agent. When the content of the organic acid containing a carboxylic acid is within the above-described range, it is possible to polish the surface to be polished containing a resin to a highly flattened state at a higher speed.

### (pH Adjusting Agent)

A polishing agent according to the present disclosure may contain a pH adjusting agent in order to adjust its pH to a predetermined value. Examples of the pH adjusting agent include, in addition to the aforementioned organic acids, inorganic acids, basic compounds, amphoteric compounds such as amino acids, and salts thereof. Note that although the above-mentioned "compound represented by Formulae (1) to (3) or a salt thereof" may also have a pH adjusting function, it is excluded from the pH adjusting agent and is regarded as a water-soluble nitrogen-containing compound in this embodiment.

Examples of the inorganic acid include nitric acid, sulfuric acid, hydrochloric acid, and phosphoric acid. Further, ammonium salts, sodium salts, and potassium salts of these acids may also be used.

Examples of the organic acid include compounds containing a carboxy group, a sulfo group or a phospho group as an acidic group, and also include an ammonium salt, a sodium salt, a potassium salt or the like of such compounds.

As the inorganic acid, nitric acid, sulfuric acid, hydrochloric acid, and phosphoric acid, as well as ammonium salts, sodium salts, and potassium salts these acids are preferred.

Further, examples of the basic compound include: ammonia, sodium hydroxide, potassium hydroxide, ammonium hydroxide, potassium carbonate, sodium carbonate, and ammonium carbonate; quaternary ammonium hydroxides such as tetramethylammonium hydroxide and tetraethylammonium hydroxide; and amino alcohols such as monoethanolamine, diethanolamine, and triethanolamine.

Only one type of pH adjusting agent may be used, or two or more types of pH adjusting agents may be used in combination.

The lower limit value of the pH of the polishing agent is 3.6, preferably 4.0, more preferably 4.4, further preferably 4.8, particularly preferably 5.2, extremely preferably 5.6, and most preferably 6.0. When the pH is 3.6 or higher, the surface potential of the surface to be polished is stabilized, so that it becomes possible to polish the surface to be polished to a highly flattened state at a high speed.

On the other hand, the upper limit value of the pH of the polishing agent is 12.0, preferably 11.4, more preferably 10.8, further preferably 10.2, still further preferably 9.6, particularly preferably 9.0, still particularly preferably 8.4, extremely preferably 7.8, and most preferably 7.2 in view of the dispersion of the abrasive grains. When the pH is 12.0 or lower, the dispersion of the abrasive grains is satisfactory.

The content ratio of the pH adjusting agent may be adjusted as appropriate so that the aforementioned pH is achieved.

### (Dispersant)

Further, a dispersant may be used in order to improve the dispersion of the abrasive grains. Examples of dispersants include anionic, cationic, nonionic, and amphoteric surfactants.

In the polishing agent according to the present disclosure, when a dispersant is used, a cationic surfactant is preferred in view of the dispersion of the abrasive grains and in order to improve the resin removal rate. By using a cationic surfactant, it is possible to polish the surface to be polished containing a resin to a highly flattened state at a higher speed.

Among others, a cationic surfactant containing a unit containing quaternary ammonium is preferred. By using a cationic surfactant containing quaternary ammonium, the affinity with the water-soluble nitrogen-containing compound becomes excellent, so that it is possible to polish the surface to be polished containing a resin to a highly flattened state at a higher speed.

The structure of the quaternary ammonium is not limited to any particular structures, but it is preferred to contain diallyldimethylammonium, diallylmethylethylammonium, and salts thereof in view of the high-speed polishing. Examples of the quaternary ammonium salt include hydrochloride, hydrobromide, acetate, sulfate, nitrate, sulfite, phosphate, amidosulfate, methanesulfonate, and ethanesulfonate.

Specific examples of the cationic surfactant include a diallyldimethylammonium chloride polymer, a diallyldimethylammonium chloride-sulfur dioxide copolymer, a diallyldimethylammonium chloride-acrylamide copolymer, a diallyldimethylammonium chloride maleic acid copolymer, and a maleic acid-diallyldimethylammonium ethyl sulfate-sulfur dioxide copolymer. Further, only one type of cationic surfactant may be used, or two or more types of cationic surfactants may be used in combination.

The weight-average molecular weight of the above-described cationic surfactant is preferably 10,000 to 100,000 in order to polish the surface to be polished containing a resin to a highly flattened state at a higher speed.

When the above-described cationic surfactant is used, its content is preferably 0.0001 to 0.1 wt.% based on the total mass of the polishing agent in order to polish the surface to be polished containing a resin to a highly flattened state at a higher speed.

### (Lubricant)

Further, a polishing agent according to the present disclosure may also contain a lubricant. A lubricant is used as required in order to improve the lubricity of the polishing agent and improve the uniformity of the removal rate on the surface. Examples of lubricants include water-soluble polymers such as polyethylene glycol and polyglycerol.

A method for preparing a polishing agent according to the present disclosure may be selected as appropriate from methods in which abrasive grains, a water-soluble polymer, and each of other components used as required are uniformly dispersed or dissolved in water which servs as a medium.

For example, it is preferred to prepare, i.e., manufacture, a polishing agent according to the present disclosure by preparing a liquid in which abrasive grains are dispersed and an aqueous solution of the above-described water-soluble nitrogen-containing compound (also referred to as an additive solution for a polishing agent) and mixing them with each other. According to this method, the storage stability of the above-described dispersion liquid and the additive solution for a polishing agent is improved and the transportation of them become easier.

It is preferred to prepare a polishing agent according to the present disclosure by performing the above-described mixing in a polishing apparatus.

### [Additive Solution for Polishing Agent]

An additive solution for a polishing agent according to this embodiment is an additive solution for preparing a polishing agent by mixing it with a liquid in which abrasive grains are dispersed as described above, and contains a water-soluble nitrogen-containing compound and water, in which the water-soluble nitrogen-containing compound contains a water-soluble nitrogen-containing compound containing a nitrogen atom having a lone electron pair.

By adding the above-described additive solution for a polishing agent to the liquid in which abrasive grains are dispersed, it is possible to polish the surface to be polished containing a resin to a highly flattened state at a high speed.

The above-described additive solution for a polishing agent contains at least a water-soluble nitrogen-containing compound and water, and may further contain as required a water-soluble polymer, a pH adjusting agent, an aggregation inhibitor, a dispersant, a lubricant, a viscosity imparting agent, a viscosity adjusting agent, a preservative, and the like.

Note that each of these components is as described above, and therefore descriptions thereof are omitted here. Note that when a polishing agent is prepared by separately preparing two liquids, i.e., a liquid in which abrasive grains are dispersed and an additive solution for a polishing agent, and then mixing them with each other, it is possible to prepare a liquid in which abrasive grains are dispersed at a concentration 2 to 100 times higher than a predetermined concentration and an additive solution for a polishing agent in which the concentration of the water-soluble nitrogen-containing compound is 2 to 100 times higher than a predetermined concentration, and then dilute them to the predetermined concentrations when the polishing agent is used. More specifically, for example, when the concentration of abrasive grains in the dispersion liquid and the concentration of the water-soluble nitrogen-containing compound in the additive solution are both 10 times their respective predetermined concentrations, a polishing agent is obtained by mixing 10 pts.mass of the dispersion liquid, 10 pts.mass of the additive solution for a polishing agent, and 80 pts.mass of water with each other, and stirring the mixture.

### [Polishing Method]

A polishing method according to this embodiment is a method for polishing a surface to be polished containing a resin by bringing the surface to be polished into contact with a polishing pad while supplying a polishing agent, and polishing the surface to be polished by relative motion of the surface to be polished and the polishing pad, in which a polishing agent according to the above-described embodiment is used as the polishing agent.

In the polishing method according to the present disclosure, the surface to be polished is a surface to be polished containing a resin, such as a resin surface used as an interlayer insulating film between wiring layers in a multilayer structure in the manufacturing of a semiconductor device.

The surface to be polished may be a surface made of resin alone, and/or may include, in addition to the resin, for example, a metal material, a stopper material, and an insulating material (excluding the resin. The same applies hereinafter.). The metal material is, for example, a wiring metal containing copper, tungsten, ruthenium, molybdenum, cobalt, or the like, or a barrier metal containing titanium, tantalum, or the like. The stopper material is, for example, silicon nitride or polysilicon. The insulating material is, for example, silicon oxide.

Examples of the resin include resin materials such as a phenolic resin, an epoxy resin, an acrylic resin, a methacrylic resin, a novolac resin, a polyester resin (such as an unsaturated polyester resin), a polyimide resin, a polyamide-imide resin, polybenzoxazole (PBO), a polyallyl ether resin, and a heterocycle-containing resin (excluding the resins exemplified above). Examples of the aforementioned "heterocycle-containing resin" include a pyrrole ring-containing resin, a pyridine ring-containing resin, an imidazole ring-containing resin. Examples of the method for forming a resin include, but are not limited to, a vapor deposition method and a spin coating method. The shape of the resin is not limited to any particular shapes. For example, the resin is in the form of a film (i.e., a resin film). The polishing agent according to this embodiment can also be used for polishing a resin substrate.

A known polishing apparatus can be used for the polishing method according to the present disclosure. Fig. 1 is a schematic diagram showing an example of a polishing apparatus. A polishing apparatus 20 shown in the example shown in Fig. 1 includes a polishing head 22 that holds a semiconductor substrate 21 having a surface to be polished containing a resin, a polishing table 23, a polishing pad 24 bonded to the surface of the polishing table 23, and a polishing agent supply pipe 26 through which a polishing agent 25 is supplied to the polishing pad 24. The polishing apparatus 20 is configured so as to polish the surface to be polished of the semiconductor substrate 21 held by the polishing head 22 by bringing the surface to be polished into contact with the polishing pad 24 while supplying the polishing agent 25 through the polishing agent supply pipe 26, and rotationally moving the polishing head 22 and the polishing table 23 relative to each other.

The polishing head 22 may perform not only the rotational movement but also a linear movement. Further, the polishing table 23 and the polishing pad 24 may have sizes roughly equal to or smaller than that of the semiconductor substrate 21. In this case, it is preferred that the polishing head 22 and the polishing table 23 are moved relative to each other, so that the entire surface to be polished of the semiconductor substrate 21 can be polished. Further, the polishing table 23 and the polishing pad 24 do not necessarily have to be those that perform rotational movements. That is, each of them may instead be, for example, moved in one direction by a belt or the like.

Although the polishing conditions of the polishing apparatus 20 are not limited to any particular conditions, it is possible to improve the removal rate by applying a load to the polishing head 22 and thereby pressing the polishing head 22 against the polishing pad 24, and thereby increasing the polishing pressure applied thereto. The polishing pressure is preferably about 0.5 kPa to 50 kPa, and more preferably about 3 kPa to 40 kPa in view of the uniformity and flatness on the surface to be polished of the semiconductor substrate 21 at the removal rate, and to prevent polishing defects such as scratches. The rotation speeds of the polishing table 23 and the polishing head 22 are preferably about 50 rpm to 500 rpm. In view of the interaction between the water-soluble nitrogen-containing compound and the resin of the surface to be polished, the temperature of the surface to be polished is preferably 30°C to 80°C, more preferably 40°C to 80°C, and further preferably 50°C to 80°C. By adjusting the temperature of the surface to be polished to 30°C or higher, the decomposition reaction of the resin by the nucleophilic action is further accelerated. On the other hand, by adjusting the temperature of the surface to be polished to 80°C or lower, the evaporation of the water contained in the polishing agent is suppressed, so that the aggregation of the abrasive grains is suppressed. Further, the amount of the polishing agent 25 to be supplied is adjusted as appropriate according to the composition of the polishing agent, the above-described polishing conditions, and the like.

As the polishing pad 24, one made of a nonwoven fabric, a foamed polyurethane, a porous resin, a nonporous resin, or the like can be used. In order to increase the supply of the polishing agent 25 to the polishing pad 24 or to make a certain amount of the polishing agent 25 remain in the polishing pad 24, grooves in a lattice pattern, a concentric circular pattern, a spiral pattern, or the like may be formed in the surface of the polishing pad 24 by machining or the like. Further, if necessary, a pad conditioner may be brought into contact with the surface of the polishing pad 24, so that the surface to be polished is polished while the surface of the polishing pad 24 is constantly conditioned.

Polishing debris caused by the polishing of the surface to be polished containing a resin have an affinity with the polishing pad, so that the polishing debris may remain on the polishing pad, and hence may deteriorate the removal rate. Therefore, it is preferred to apply a sufficient pad conditioning pressure. That is, the pad conditioning pressure is preferably about 13 N to 45 N, more preferably 22 N to 45 N, and further preferably 40 N to 45 N.

According to the polishing method in accordance with the present disclosure, it is possible to polish a surface to be polished containing a resin at a high speed while suppressing polishing damage.

### Examples

The present invention will be described hereinafter in a more detailed manner with reference to examples and comparative examples, but the present invention is not limited to these examples. Note that Examples 3-33, 35, 37, 39 and 41 are examples according to the present disclosure, and Examples 1, 2, 34, 36, 38 and 40 are comparative examples.

### [Measuring Method]

### <pH>

The pH was measured at a temperature of 25±5°C by using a pH meter HM-30R manufactured by DKK-TOA Corporation.

### <Average Secondary Particle size>

The average secondary particle size was measured by using a laser scattering/diffraction type particle-size distribution measurement apparatus (manufactured by HORIBA, Ltd., apparatus name: LA-950).

### <Weight-Average Molecular Weight (Mw)>

The weight-average molecular weight was measured by gel permeation chromatography (GPC) under the following conditions.
- Apparatus HLC-8320GPC (manufactured by TOSOH Corporation)
- Column TSKgel GMPWXL (manufactured by TOSOH Corporation)
- Detector RI Detector polarity (+)
- Eluent 0.2M-NaNO₃ aqueous solution
- Flow rate 1.0 mL/min column temperature 40°C
- Calculated in terms of Standard PEO/PEG

### [Polishing]

Polishing characteristics were measured and evaluated by using a fully automatic CMP polishing apparatus (manufactured by Applied Materials; apparatus name: Mirra) for examples in which the surface to be polished was made of polyimide. A two-layer pad (IC-1400 manufactured by NITTA DuPont Incorporated, K-groove) was used as the polishing pad, and a diamond pad conditioner (manufactured by 3M, product name: A165) was used for the conditioning of the polishing pad. The polishing conditions were as follows: the polishing pressure was 27.6 kPa; the rotation speed of the polishing table was 127 rpm; and the rotation speed of the polishing head was 123 rpm. Further, the supplying speed of the polishing agent was 200 ml/min.

Examples in which the surface to be polished was made of epoxy resin, measurement and evaluation were carried out by using a manual CMP experimental apparatus (manufactured by Mirapro Advanced Technology Co., Ltd., apparatus name: MAT-ARW-461MII). A two-layer pad (IC-1400 manufactured by NITTA DuPont Incorporated, K-groove) was used for the polishing pad, and a diamond pad conditioner (CMP-MP-100A manufactured by Asahi Diamond Industrial Co., Ltd.) was used for the conditioning of the polishing pad. The polishing conditions were as follows: the polishing pressure was 27.6 kPa; the rotation speed of the polishing table was 77 rpm; and the rotation speed of the polishing head was 73 rpm. Further, the supplying speed of the polishing agent was 200 ml/min.

### [Abrasive Gains]

### <Abrasive Gains A>

0.25 wt.% of abrasive grains mainly consisting of ceria particles (average secondary particle size 80 nm to 90 nm) were contained in the polishing agent based on the total mass of the polishing agent. Note that the content of ceria to the total mass of the abrasive grains was 95% or more.

### <Abrasive Gains B>

0.25 wt.% of abrasive grains mainly consisting of alumina particles (average secondary particle size 120 nm) were contained in the polishing agent based on the total mass of the polishing agent. Note that the content of alumina to the total mass of the abrasive grains was 95% or more.

### <Abrasive Gains C>

0.25 wt.% of abrasive grains mainly consisting of silica particles (average secondary particle size 70 nm) were contained in the polishing agent based on the total mass of the polishing agent. Note that the content of silica to the total mass of the abrasive grains was 95% or more.

### [Object to be Polished]

Objects made of the following materials were used as objects to be polished.
- Polyimide: Blanket substrate in which a film of polyimide was formed on an 8-inch silicon wafer.
- Epoxy resin: Blanket substrate in which an epoxy film was formed on a square silicon wafer each side of which was 5 cm.

### [Removal Rate]

For the measurement of the film thickness of each film, a film-thickness meter UV-1280SE available from KLA-Tencor was used for the examples in which the surface to be polished was made of polyimide, and the removal rate was calculated based on the time and the change in the film thickness.

For the examples in which the surface to be polished was made of epoxy resin, the removal rate was calculated by the following formula. - Removal rate (A/min) = [(Substrate weight (g) before polishing) - (Substrate weight (g) after polishing)]/Density of epoxy film (g/cm3)/Area of Substrate (cm2)/Polishing time (min) ×10,000,000

### [Flatness]

As the evaluation criterion of flatness, the uniformity of the removal rate on the wafer surface was used. 40 or more removal rate measurement points were defined along the diameter direction of the wafer. Then, when the coefficient of variation was 20% or higher, the flatness was determined to be poor (×), whereas when the coefficient of variation was lower than 20%, the flatness was determined to be satisfactory (∘).

### - Examples in which the surface to be polished is made of polyimide

### [Examples 1, 2, 34, 36]

Each of the abrasive grains A (ceria), abrasive grain B (alumina), and abrasive grains C(silica) was separately dispersed in water. In Examples 1 and 34, this solution was used as a polishing agent, and in Examples 2 and 36, a solution that was obtained by adding an inorganic acid shown in Table 1 to the aforementioned solution was used as a polishing agent. Note that the content of each of all the types of abrasive grains, including those described later, was adjusted to 0.25 wt.% in the polishing agent.

### [Examples 3, 33, 35, 37]

A polishing agent was prepared by adding abrasive grains A, B or C, a water-soluble nitrogen-containing compound shown in Table 1, and additives (a dispersant, an organic acid, and an inorganic acid) while adjusting their contents to those shown in Table 1. Note that the symbol "-" in Table 1 indicates that nothing was added.

### [Table 1]

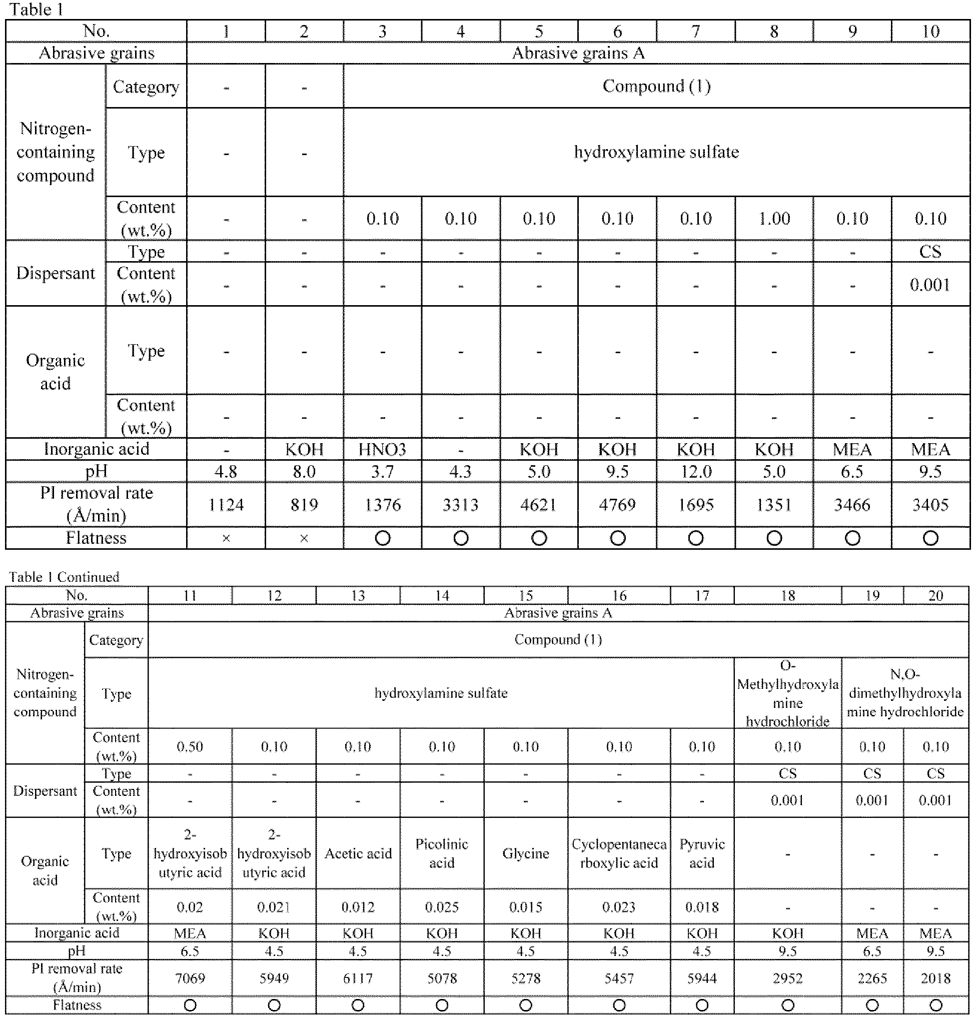

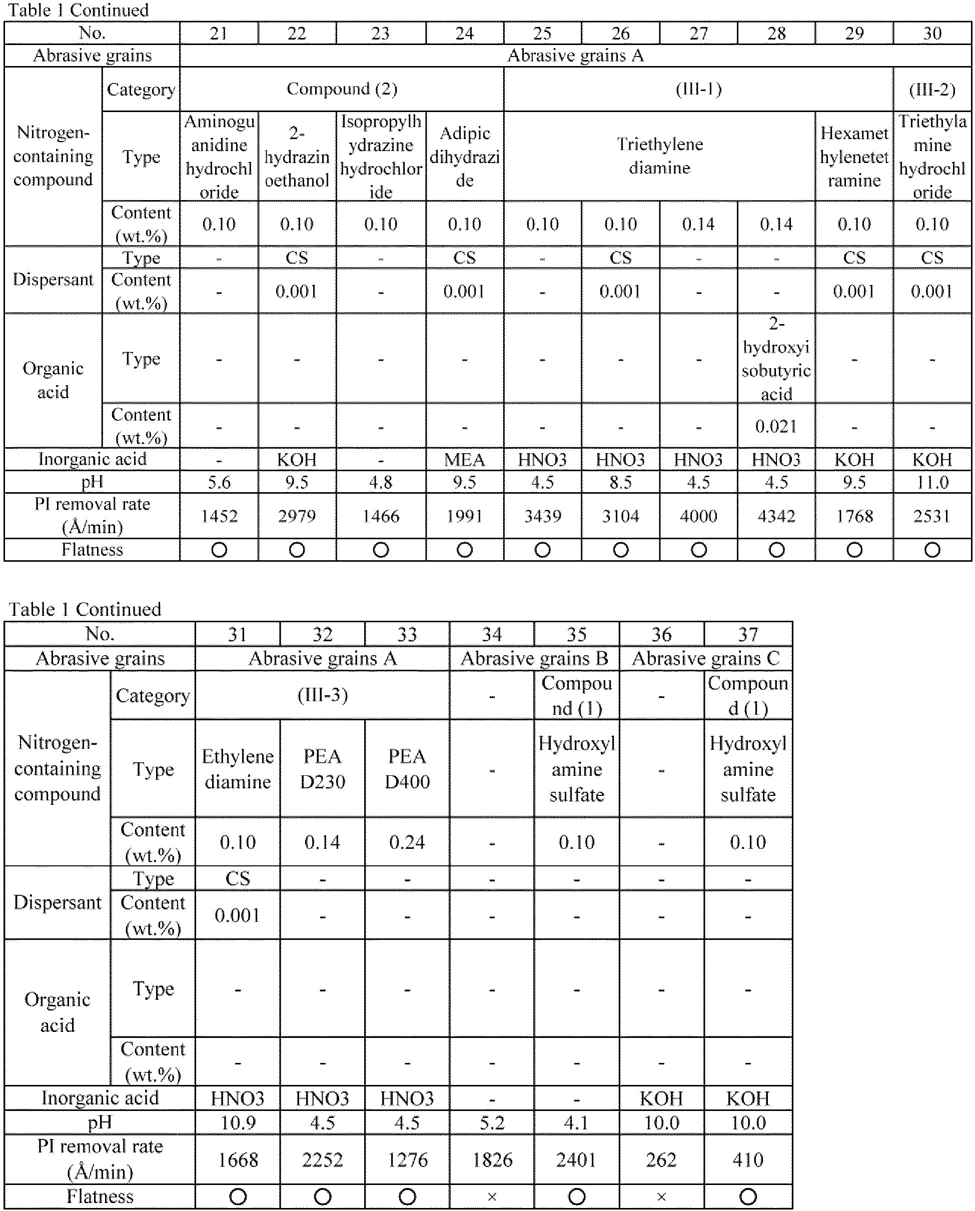

### - Examples in which the surface to be polished is made of epoxy resin

### [Examples 38 and 40]

Each of the abrasive grains A (ceria) and B abrasive grains (alumina) was separately dispersed in water while adjusting their contents to those shown in Table 2. In Example 40, this solution was used as a polishing agent, and in Example 38, a solution that was obtained by adding a dispersant and an inorganic acid shown in Table 2 to the aforementioned solution was used as a polishing agent.

### [Examples 39 and 41]

A polishing agent was prepared by adding abrasive grains A or B, a water-soluble nitrogen-containing compound shown in Table 2, and an additive(s) while adjusting their contents to those shown in Table 2, and further adding a pH adjusting agent. Note that the symbol "-" in Table 2 indicates that nothing was added.

### [Table 2]

**Table 2**

| No. | | 38 | 39 | 40 | 41 |
|---|---|---|---|---|---|
| Abrasive grains | | Abrasive grains A | | Abrasive grains B | |
| Nitrogen-containing compound | Category | - | Compound (1) | - | Compound (1) |
| | Type | - | Hydroxylamine sulfate | - | Hydroxylamine sulfate |
| | Content (wt.%) | - | 0.10 | - | 0.10 |
| Dispersant | Type | CS | CS | - | - |
| | Content (wt.%) | 0.001 | 0.001 | - | - |
| Organic acid | Type | - | - | - | - |
| | Content (wt.%) | - | - | - | - |
| Inorganic acid | | KOH | KOH | - | - |
| pH | | 10.1 | 10.0 | 4.9 | 4.0 |
| PI removal rate (Å/min) | | 543 | 1010 | 171 | 375 |
| Flatness | | × | ○ | × | ○ |

Abbreviations and the like in Tables 1 and 2 are as follows.
- PI: Polyimide
- PEA D230: Polyetheramine D230 (molecular weight 230)
   (manufactured by BASF)
- PEA D400: Polyetheramine D400 (molecular weight 400)
   (manufactured by BASF)
- HNO3: Nitric acid
- MEA: Monoethanolamine
- KOH: Potassium hydroxide
- CS: Cationic surfactant

### [Summary of Results]

As being obvious from the comparison between Examples 1 and 2 and Examples 3 to 33, it was shown that for the polishing agent containing the compound represented by the above-shown Formulae (1) to (3) or a salt thereof, the removal rate of the surface to be polished containing a resin was remarkably improved and the flatness was also excellent. Further, as shown in the comparison between Examples 3 to 10 and Examples 11 to 17, and the comparison between Examples 25 and 27 and Example 28, it has been found that for the polishing agent containing a nitrogen-containing compound and an organic acid, the removal rate of the surface to be polished containing a resin was further improved.

Further, as shown in the comparison between Example 34 and Example 35 and the comparison between Example 36 and Example 37, it has also been found that even when the abrasive grains were changed to alumina particles or silica particles, the removal rate was remarkably improved by the compound represented by the above-shown Formulae (1) to (3) or a salt thereof.

Further, as shown in the comparison between Example 38 and Example 39 and the comparison between Example 40 and Example 41, it has also been found that even when the surface to be polished was made of epoxy resin, the removal rate was remarkably improved by the compound represented by the above-shown Formulae (1) to (3) or a salt thereof. Therefore, it has been shown that the use of a polishing agent according to the present disclosure makes it possible to perform high-speed polishing for various resin surfaces.

As described above, a polishing agent according to this embodiment is particularly excellent for polishing a surface to be polished containing a resin.

This application is based upon and claims the benefit of priorities from Japanese patent application No. 2022-142276, filed on September 7, 2022, and Japanese patent application No. 2023-30924, filed on March 1, 2023. the disclosures of both of which are incorporated herein in their entirety by reference.

### Reference Signs List

- 20: POLISHING APPARATUS
- 21: SEMICONDUCTOR SUBSTRATE
- 22: POLISHING HEAD
- 23: POLISHING TABLE
- 24: POLISHING PAD
- 25: POLISHING AGENT
- 26: POLISHING AGENT SUPPLY PIPE

## Claims

1. A polishing agent for polishing a surface to be polished containing a resin, containing abrasive grains, a water-soluble nitrogen-containing compound, and water, wherein
the water-soluble nitrogen-containing compound contains a compound represented by below-shown Formulae (1) to (3) or a salt thereof: 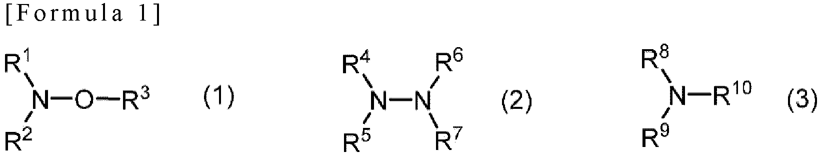
where:
(I) each of R¹ to R³ independently represents a hydrogen atom, an alkyl group which may contain a substituent and may contain an ether bond between carbon and carbon, an aryl group which may contain a substituent and may contain a hetero atom, or a group represented by a below-shown Formula (1a), 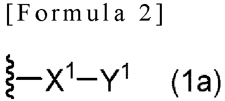
X¹ represents -C(=O)-, -C(=O)-O-, -C(=O)-NH-, -C(=S)-O-, - C(=S)-S-, -S (=O)(=O)-, or -C(=NH)-NH-,
Y¹ represents a hydrogen atom, an alkyl group which may contain a substituent and may contain an ether bond between carbon and carbon, an aryl group which may contain a substituent and may contain a hetero atom, a hydroxyl group, or an amino group,
two groups selected from R¹ to R³ may be connected to each other and thereby form a ring structure,
(II) each of R⁴ to R⁷ independently represents a hydrogen atom, an alkyl group which may contain a substituent and may contain an ether bond between carbon and carbon, an aryl group which may contain a substituent and may contain a hetero atom, a group represented by a below-shown Formula (2a), or a group represented by a below-shown Formula (2b), 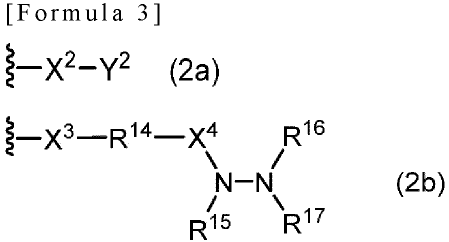
X² represents a group selected from -C(=)-, -C(=O)-O-, -C(=O)-NH-, -C(=S)-O-, -C(=S)-S-, -S (=O)(=O)-, and -C(=NH)-NH-,
Y² represents a hydrogen atom, an alkyl group which may contain a substituent and may contain an ether bond between carbon and carbon, an aryl group which may contain a substituent and may contain a hetero atom, a hydroxyl group, or an amino group;
X³ represents -C(=O)-, -C(=O)-O-, -C(=O)-NH-, -C(=S)-O-, - C(=S)-S-, -S (=O)(=O)-, or -C(=NH)-NH-,
R¹⁴ represents a single bond or an alkylene group which may contain a substituent and may contain an ether bond between carbon and carbon,
X⁴ represents a single bond, -C(=O)-, -C(=O)-O-, -C(=O)-NH-, - C(=S)-O-, -C(=S)-S-, -S (=O)(=O)-, or -C(=NH)-NH-,
each of R¹⁵ to R¹⁷ independently represents a hydrogen atom, an alkyl group which may contain a substituent and may contain an ether bond between carbon and carbon, an aryl group which may contain a substituent and may contain a hetero atom, or a group represented by the above-shown Formula (2a),
two groups selected from R⁴ to R⁷ may be connected to each other and thereby form a ring structure,
two groups selected from R¹⁵ to R¹⁷ may be connected to each other and thereby form a ring structure,
(III) each of R⁸ to R¹⁰ independently represents a hydrogen atom, an alkyl group which may contain an aryl group, an amino group, or a halogen atom as a substituent and may contain an ether bond between carbon and carbon, or a group represented by a below-shown Formula (3a), where at least one of R⁸ to R¹⁰ is a group other than a hydrogen atom, 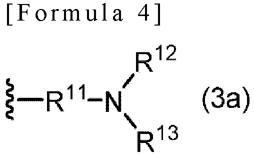
R¹¹ represents an alkylene group which may contain a substituent and may contain an ether bond between carbon and carbon,
each of R¹² and R¹³ independently represents a hydrogen atom, or an alkyl group which may contain a substituent and may contain an ether bond between carbon and carbon, and
two or three atoms or groups selected from R⁸ to R¹⁰ may be connected to each other and thereby form a ring structure.

2. The polishing agent according to claim 1, wherein the water-soluble nitrogen-containing compound contains a compound represented by the above-shown Formula (1) or a salt thereof.

3. The polishing agent according to claim 2, wherein the compound represented by the above-shown Formula (1) contains at least one compound selected from hydroxylamine, N-methylhydroxylamine, N-hydroxyacetamide, N-hydroxycarbamate-tert-butyl, hydroxyurea, O-methylhydroxylamine, O-(tetrahydropyran-2-yl)hydroxylamine, carboxymethoxylamine, N,O-dimethylhydroxylamine, and N,N-dimethylhydroxylamine.

4. The polishing agent according to claim 2, wherein the compound represented by the above-shown Formula (1) contains at least one compound selected from hydroxylamine, O-methylhydroxylamine, and N,O-dimethylhydroxylamine.

5. The polishing agent according to claim 1, wherein the water-soluble nitrogen-containing compound contains a compound represented by the above-shown Formula (2) or a salt thereof.

6. The polishing agent according to claim 5, wherein the compound represented by the above-shown Formula (2) contains at least one compound selected from hydrazine, formohydrazide, acetohydrazide, tert-butoxycarbonylhydrazine, isonicotinic acid hydrazide, adipic acid dihydrazide, carbohydrazide, 1,1-dimethylhydrazine, 1-pyrrolidineamine, 4-aminomorpholine, 1-aminopiperidine, 1-amino-4-methylpiperazine, thiosemicarbazide, thiocarbohydrazide, oxamic acid hydrazide, 4-methylthiosemicarbazide, aminoguanidine, 1,3-diaminoguanidine, semicarbazide, N-aminophthalimide, 2-hydrazinoethanol, isopropylhydrazine, methylhydrazine, cyclohexylhydrazine, phenylhydrazine, and 2-hydrazinopyridine.

7. The polishing agent according to claim 5, wherein the compound represented by the above-shown Formula (2) contains at least one compound selected from aminoguanidine, 2-hydrazinoethanol, isopropylhydrazine, and adipic acid dihydrazide.

8. The polishing agent according to claim 1, wherein
the water-soluble nitrogen-containing compound contains a compound represented by the above-shown Formula (3) or a salt thereof,
at least two groups among R⁸ to R¹⁰ are groups other than a hydrogen atom,
two groups selected from R⁸ to R¹⁰ are connected to each other through a divalent connecting group and thereby form a ring structure, or
three atoms or groups of R⁸ to R¹⁰ are connected to each other through a trivalent connecting group and thereby form a ring structure.

9. The polishing agent according to claim 8, wherein the compound represented by the above-shown Formula (3) contains at least one compound selected from triethylenediamine, hexamethylenetetramine, quinuclidine, 3-quinuclidinol, 3-quinuclidinone, quinidine, quinine, cinchonidine, cinchonine, piperazine, and 4-dimethylaminopyridine.

10. The polishing agent according to claim 8, wherein the compound represented by the above-shown Formula (3) contains at least one compound selected from triethylenediamine and hexamethylenetetramine.

11. The polishing agent according to claim 1, wherein
the water-soluble nitrogen-containing compound contains a compound represented by the above-shown Formula (3) or a salt thereof, and
each of R⁸ to R¹⁰ independently represents an alkyl group which may contain a substituent and may contain an ether bond between carbon and carbon, and a molecular weight (in a case of a salt, a molecular weight of only a part represented by Formula (3)) is 500 or smaller.

12. The polishing agent according to claim 11, wherein the compound represented by the above-shown Formula (3) contains at least one compound selected from trimethylamine and triethylamine.

13. The polishing agent according to claim 11, wherein the compound represented by the above-shown Formula (3) contains triethylamine.

14. The polishing agent according to claim 1, wherein
the water-soluble nitrogen-containing compound contains a compound represented by the above-shown Formula (3) or a salt thereof, and
each of R⁸ to R¹⁰ independently represents a hydrogen atom or a group represented by the above-shown Formula (3a), where: at least one of R⁸ to R¹⁰ represents a group other than a hydrogen atom; R¹² and R¹³ are hydrogen atoms; and a molecular weight (in a case of a salt, a molecular weight of only a part represented by Formula (3)) is 500 or smaller.

15. The polishing agent according to claim 14, wherein the compound represented by the above-shown Formula (3) contains at least one compound selected from ethylenediamine, propylenediamine, butylenediamine, and polyetheramine.

16. The polishing agent according to claim 14, wherein the compound represented by the above-shown Formula (3) contains at least one compound selected from ethylenediamine and polyetheramine.

17. The polishing agent according to claim 1, wherein a content of the water-soluble nitrogen-containing compound is 0.001 wt.% to 1.5 wt.% based on a total mass of the polishing agent.

18. The polishing agent according to claim 1, wherein the abrasive grains contain at least one compound selected from the group consisting of silica particles, alumina particles, zirconia particles, ceria particles, titania particles, germania particles, cerium hydroxide particles, and composite particles thereof.

19. The polishing agent according to claim 18, wherein the abrasive grains contain ceria particles.

20. The polishing agent according to claim 1, wherein a content of the abrasive grains is 0.01 wt.% to 10.0 wt.% based on a total weight of the polishing agent.

21. The polishing agent according to claim 1, further comprising a pH adjusting agent.

22. The polishing agent according to claim 21, wherein the pH adjusting agent contains at least one compound selected from nitric acid, sulfuric acid, hydrochloric acid, phosphoric acid, sodium hydroxide, potassium hydroxide, ammonium hydroxide, potassium carbonate, sodium carbonate, ammonium carbonate, monoethanolamine, diethanolamine, and triethanolamine.

23. The polishing agent according to claim 1, further comprising an organic acid.

24. The polishing agent according to claim 23, wherein the organic acid is a monovalent monocarboxylic acid.

25. The polishing agent according to claim 23, wherein the organic acid contains at least one compound selected from acetic acid, picolinic acid, cyclopentanecarboxylic acid, glycine, 2-hydroxyisobutyric acid, and pyruvic acid.

26. The polishing agent according to claim 1, wherein pH is 3.6 to 12.0.

27. A polishing method for polishing a surface to be polished containing a resin by bringing the surface to be polished into contact with a polishing pad while supplying a polishing agent, and polishing the surface to be polished by relative motion of the surface to be polished and the polishing pad, wherein a polishing agent according to any one of claims 1 to 26 is used as the polishing agent.

28. The polishing method according to claim 27, wherein a temperature of the surface to be polished during the polishing is 30°C to 80°C.

29. The polishing method according to claim 27, wherein a pad conditioning pressure during the polishing is 13 N to 45 N.

30. An additive solution for a polishing agent used to polish a surface to be polished containing a resin, containing a water-soluble nitrogen-containing compound and water, wherein
the water-soluble nitrogen-containing compound contains a compound represented by below-shown Formulae (1) to (3) or a salt thereof: 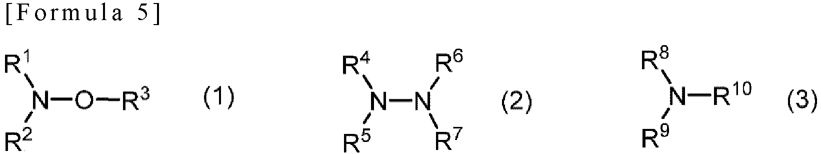
where:
(I) each of R¹ to R³ independently represents a hydrogen atom, an alkyl group which may contain a substituent and may contain an ether bond between carbon and carbon, an aryl group which may contain a substituent and may contain a hetero atom, or a group represented by a below-shown Formula (1a), 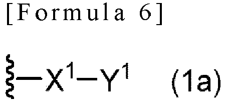
X¹ represents -C(=O)-, -C(=O)-O-, -C(=O)-NH-, -C(=S)-O-, - C(=S)-S-, -S (=O)(=O)-, or -C(=NH)-NH-,
Y¹ represents a hydrogen atom, an alkyl group which may contain a substituent and may contain an ether bond between carbon and carbon, an aryl group which may contain a substituent and may contain a hetero atom, a hydroxyl group, or an amino group,
two groups selected from R¹ to R³ may be connected to each other and thereby form a ring structure,
(II) each of R⁴ to R⁷ independently represents a hydrogen atom, an alkyl group which may contain a substituent and may contain an ether bond between carbon and carbon, an aryl group which may contain a substituent and may contain a hetero atom, a group represented by a below-shown Formula (2a), or a group represented by a below-shown Formula (2b), 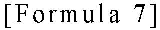 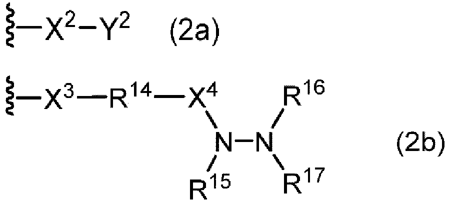
X² represents a group selected from -C(=)-, -C(=O)-O-, -C(=O)-NH-, -C(=S)-O-, -C(=S)-S-, -S (=O)(=O)-, and -C(=NH)-NH-,
Y² represents a hydrogen atom, an alkyl group which may contain a substituent and may contain an ether bond between carbon and carbon, an aryl group which may contain a substituent and may contain a hetero atom, a hydroxyl group, or an amino group;
X³ represents -C(=O)-, -C(=O)-O-, -C(=O)-NH-, -C(=S)-O-, - C(=S)-S-, -S (=O)(=O)-, or -C(=NH)-NH-,
R¹⁴ represents a single bond or an alkylene group which may contain a substituent and may contain an ether bond between carbon and carbon,
X⁴ represents a single bond, -C(=O)-, -C(=O)-O-, -C(=O)-NH-, - C(=S)-O-, -C(=S)-S-, -S (=O)(=O)-, or -C(=NH)-NH-,
each of R¹⁵ to R¹⁷ independently represents a hydrogen atom, an alkyl group which may contain a substituent and may contain an ether bond between carbon and carbon, an aryl group which may contain a substituent and may contain a hetero atom, or a group represented by the above-shown Formula (2a),
two groups selected from R⁴ to R⁷ may be connected to each other and thereby form a ring structure,
two groups selected from R¹⁵ to R¹⁷ may be connected to each other and thereby form a ring structure,
(III) each of R⁸ to R¹⁰ independently represents a hydrogen atom, an alkyl group which may contain an aryl group, an amino group, or a halogen atom as a substituent and may contain an ether bond between carbon and carbon, or a group represented by a below-shown Formula (3a), where at least one of R⁸ to R¹⁰ is a group other than a hydrogen atom, 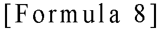 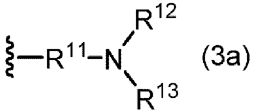
R¹¹ represents an alkylene group which may contain a substituent and may contain an ether bond between carbon and carbon,
each of R¹² and R¹³ independently represents a hydrogen atom, or an alkyl group which may contain a substituent and may contain an ether bond between carbon and carbon, and
two or three atoms or groups selected from R⁸ to R¹⁰ may be connected to each other and thereby form a ring structure.
